# EUROPÄISCHE PATENTSCHRIFT

(11) **EP 0 584 621 B1**
(45) Veröffentlichungstag und Bekanntmachung des Hinweises auf die Patenterteilung: **12.04.1995**
(21) Anmeldenummer: 93112721.1
(22) Anmeldetag: 09.08.1993
(51) Int. Cl.: H02M 3/335

(54) **Durchflussumrichter mit RCD-Entlastungsnetzwerk**
Forward DC-DC converter with RCD snubber circuit
Convertisseur direct de courant continu avec circuit Diode/résistance/capacité d'amortissement

(30) Priorität: 28.08.1992 DE 4228762
(43) Veröffentlichungstag der Anmeldung: 02.03.1994
(73) Patentinhaber: SIEMENS AKTIENGESELLSCHAFT, 80333 München (DE)
(72) Erfinder: Nonnenmacher, Ulrich, D-82131 Gauting (DE); Wagner, Franz, D-81541 München (DE)

(56) Entgegenhaltungen:
- DE-B- 2 624 800

## Beschreibung

Die Erfindung bezieht sich auf einen wie im Oberbegriff des Patentanspruchs 1 angegebenen Durchflußumrichter.

Ein derartiger Durchflußumrichter ist bereits aus der DE-B-Z624800 und aus der Druckschrift Schaltnetzteile, Konzepte Bauelemente Anwendungen von Walter Hirschmann und Alfred Hauenstein, Siemens AG, 1990, Seite 321 bekannt. Bei der bekannten Schutzschaltung liegt parallel zu dem zu schützenden Leistungsschalter eine Serienschaltung aus einem Kondensator und einer Diode, wobei parallel zur Diode ein Widerstand angeordnet ist.

Ferner ist aus der DE-B-19 56 145 bereits eine Schaltungsanordnung zum Schutz von induktiv belasteten Schalttransistoren gegen Überspannungen bekannt, die für einen Gegentakt- Umrichter vorgesehen ist. Parallel zu den beiden Leistungsschaltern des Gegentaktumrichters ist jeweils eine Serienschaltung aus Kondensator und Diode angeordnet. Der Widerstand, über den der Kondensator entladen wird, ist nicht unmittelbar parallel zum Kondensator angeordnet, sondern über eine Z-Diode oder die Kollektor-Emitterstrecke eines Hilfstransistors an den dem Kondensator abgewandten Anschluß der Eingangsgleichspannungsquelle geführt.

Bei der Schaltungsvariante mit Z-Diode ist die Zenerspannung etwa gleich der Versorgungsspannung. Die Z-Diode ist so gepolt, daß sich der Kondensator in jedem Schaltzyklus des zu schützenden Transistors etwa bis auf die doppelte Höhe der Versorgungsspannung entladen kann. Bei der Schaltungsvariante mit Hilfstransistor ist der Hilfstransistor leitend gesteuert, solange der zu schützende Transistor gesperrt ist.

Auf diese Weise wird erreicht, daß der Kondensator höchstens bis auf den einfachen oder doppelten Wert der Versorgungsspannung entladen wird. Während der sperrenden Phase des zu schützenden Schalttransistors entlädt sich der Kondensator unter Vermeidung unnötiger Verluste nur noch bis auf den einfachen bzw. doppelten Wert der Versorgungsspannung. Außerdem wird ein erheblicher Teil der Energie in die Eingangsgleichspannungsquelle zurückgespeist.

Ein parallel zum Leistungsschalter angeordnetes RCD-Entlastungsnetzwerk schützt den betreffenden Leistungsschalter beim Ausschalten vor zu großen Schaltverlusten durch gleichzeitiges Auftreten von Strom und Spannung. Zugleich sorgt es für eine Verringerung der Flankensteilheit der am Schalter auftretenden Spannung und bedämpft überlagerte hochfrequente Einschwingvorgänge, was im Hinblick auf eine Funkentstörung von Vorteil ist. Andererseits entsteht beim Ausschalten des Leistungsschalters ein Serienschwingkreis, bestehend aus der Übertrager-Hauptinduktivität und dem Kondensator der Beschaltung. Dieser Schwingkreis bewirkt ein sinusförmiges Überschwingen der Spannung am Leistungsschalter. Das Entlastungsnetzwerk spielt daher auch bei der Abmagnetisierung des Leistungsübertragers eine wesentliche Rolle. Schließlich werden unzulässig hohe Spannungsspitzen am Leistungstransistor unterdrückt, die durch das schnelle Abschalten des Stromes in Folge von Leitungsinduktivität und Streuinduktivitäten des Leistungsübertragers entstehen könnten.

Das RCD-Entlastungsnetzwerk hat somit eine Reihe von Vorteilen. Allerdings wird beim Wiedereinschalten des Leistungsschalters die im Kondensator gespeicherte Energie in Verlustwärme überführt und der Leistungsschalter muß den Entladestrom zusätzlich führen. Außerdem wird beim Überschwingen der Kondensatorspannung in der Sperrphase und bei der damit erfolgenden Ummagnetisierung des Übertragers auch eine nicht zu vernachlässigende Menge an Energie in den oder die Ausgangskreise transformiert. Dies kann bei schwacher Belastung zu lückendem Betrieb oder z.B. bei EMK-geregelten Geräten im Leerlauf sogar zu einem unzulässigen Anstieg der Ausgangsspannung führen. Ein lückender Betrieb ist jedoch insbesondere bei Geräten mit mehreren Ausgangskreisen nicht ohne weiteres zu akzeptieren.

Um die genannten Nachteile zu vermeiden, kann man eine relativ große Vorlast vorsehen. Diese verschlechtert jedoch den Wirkungsgrad der Schaltung insbesondere bei vergleichsweise geringer Belastung erheblich und erwärmt das Gerät zusätzlich.

Aufgabe der Erfindung ist es, einen Durchflußumrichter zu schaffen, dessen Entlastungsnetzwerk bei stark schwankender Last des Durchflußumrichters hinsichtlich Wirksamkeit der Entlastung und Verlustleistung selbsttätig an den jeweiligen Belastungsfall angepaßt ist.

Gemäß der Erfindung wird der Durchflußumrichter zur Lösung der gestellten Aufgabe in der im kennzeichnenden Teil des Patentanspruchs 1 angegebenen Weise ausgebildet.

Ein derartiger Durchflußumrichter bietet in vorteilhafter Weise sowohl eine wirksame Entlastung des Leistungsschalters bei hoher Ausgangsleistung als auch einen hohen Wirkungsgrad bei vergleichsweise geringer Belastung des Durchflußumrichters.

Dieser Vorteil ist insbesondere bei der Stromversorgung von Einrichtungen der Nachrichten-Vermittlungstechnik von wesentlicher Bedeutung, bei denen Umrichter im Durchschnitt sehr gering belastet sind und dabei aus Erwärmungsgründen einen hohen Wirkungsgrad aufweisen sollen. Der Durchflußumrichter ist daher besonders zur verlustarmen Speisung von Vermittlungseinrichtungen geeignet, die zu Stoßzeiten eine vergleichsweise große Leistung benötigen, im Stand-by-Betrieb dagegen mit einer vergleichsweise geringen Leistung auskommen.

Vorteilhafte Ausgestaltungen und Weiterbildungen der Erfindung sind Gegenstand der Unteransprüche.

Die Erfindung wird anhand der in den Figuren dargestellten Ausführungsbeispiele näher erläutert.

Es zeigen
- Fig. 1: einen Durchflußumrichter mit zwei, durch einen Hilfstransistor wahlweise aktivierbaren Entlastungsnetzwerken,
- Fig. 2: einen Durchflußumrichter nach Fig. 1 mit abgewandelter Ansteuerung des Hilfstransistors und
- Fig. 3: eine Anordnung zu einer mit der Eingangsspannung gewichteten Mittelwertbildung des eingangsseitigen Pulsstromes,
- Fig. 4: eine Anordnung mit einem Analog-Multiplizierer und
- Fig. 5: einen Durchflußumrichter mit Regelung der Ausgangsspannung durch unterlagerte Stromregelung.

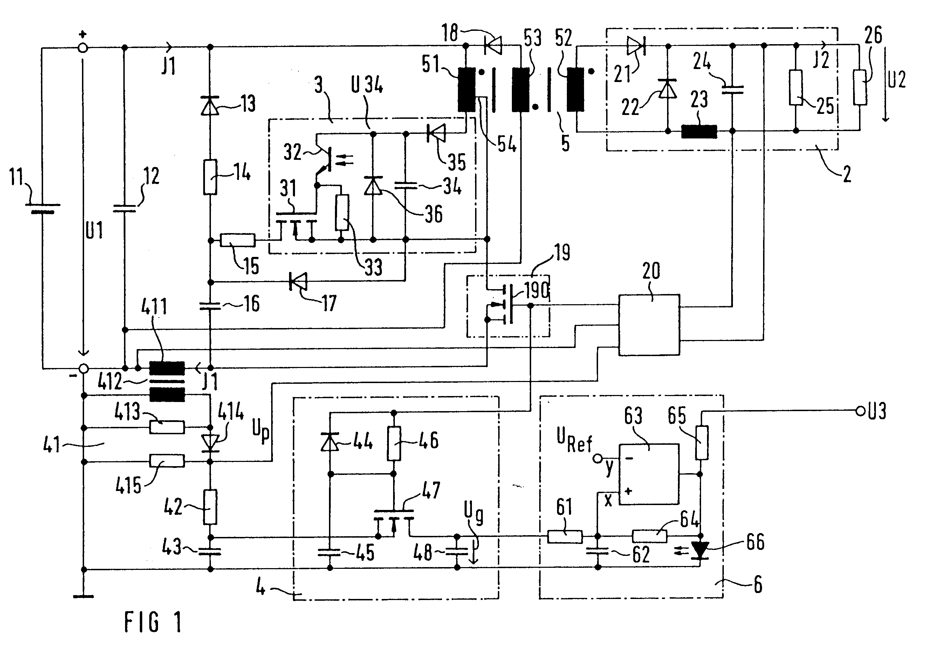

Fig. 1 zeigt einen Eintakt-Durchflußumrichter mit einem Leistungsschalter 19. Die von der Gleichspannungsquelle 11 gelieferte Eingangsspannung U1 liegt am Kondensator 12, die Ausgangsspannung U2 am Kondensator 24. Parallel zum Kondensator 12 liegt in einem primärseitigen Hauptstromkreis eine aus der Primärwicklung 51 des Transformators 5, dem Leistungsschalter 19 und dem Stromwandler 41 gebildete Serienschaltung. Der Leistungsschalter 19 ist mit seinem Steuereingang an die Steuerschaltung 20 angeschlossen, die taktgesteuert eine Folge von, insbesondere impulsdauermodulierten, Einschaltimpulsen abgibt.

Die Primärwicklung 51 des Transformators 5 wird daher über den Leistungsschalter 19 periodisch an die Eingangsspannungsquelle 11 gelegt. Als Schalttransistor für den Leistungsschalter 19 dient der Feldeffekttransistor 190.

Zwischen der Sekundärwicklung 52 des Transformators 5 und dem Kondensator 24 liegt die Gleichrichterdiode 21. In einem auf die Gleichrichterdiode 21 folgenden Querzweig ist die Freilaufdiode 22 angeordnet. In einem Längszweig zwischen Freilaufdiode 22 und Kondensator 24 liegt die Drossel 23. Parallel zum Kondensator 24 liegt der Widerstand 25. An der Parallelschaltung von Kondensator 24 und Widerstand 25 steht die Ausgangsspannung U2 für den Lastwiderstand 26 zur Verfügung. In den mit der Ausgangsspannung U2 gespeisten, einen Verbraucher bildenden Lastwiderstand 26 fließt der Ausgangsstrom I2.

Mit Hilfe des Feldeffekttransistors 31 wird in Abhängigkeit von der Belastung des Durchflußumrichters eines von zwei Entlastungsnetzwerken wirksam geschaltet. Ein erstes Entlastungsnetzwerk besteht aus dem Widerstand 15, dem Kondensator 16 und der Diode 17 und sorgt bei großer Belastung des Durchflußumrichters für eine wirksame Ausschaltentlastung des elektronischen Schalters 19. Ein zweites Entlastungsnetzwerk besteht aus der Diode 17, dem Kondensator 16, dem Widerstand 14 und der Diode 13 und bewirkt eine ausreichende Ausschaltentlastung des Leistungsschalters 19 bei kleiner Belastung des Durchflußumrichters.

Beide Entlastungsnetzwerke sind in einer umschaltbaren Gesamtanordnung enthalten. Diese Gesamtanordnung enthält die aus der Diode 17 und dem Kondensator 16 bestehende, parallel zur Drain-Source-Strecke des den Leistungsschalter 19 bildenden Feldeffekttransistors angeordnete Serienschaltung. Parallel zur Diode 17 liegt die aus dem zum Widerstand 15 und der Drain-Source-Strecke des Feldeffekttransistors 31 bestehende Serienschaltung. Dabei ist der Kondensator 16 einpolig mit der Source des den Leistungsschalter 19 bildenden Feldeffekttransistors verbunden. Die Diode 17 ist in bezug auf die Eingangsspannung U1 in Durchlaßrichtung gepolt.

Der Verbindungspunkt von Diode 17 und Kondensator 16 ist über den Widerstand 14 und die dazu in Serie angeordnete und in bezug auf die Eingangsspannung U1 in Sperrichtung gepolte Diode 13 an die Eingangsspannungsquelle 11 geführt.

Der Feldeffekttransistor 31 dient als elektronischer Schalter, mit dessen Hilfe zur Umschaltung von einem der beiden Entlastungsnetzwerke auf das andere der Widerstand 15 wahlweise wirksam oder unwirksam geschaltet wird. Bei Starklast ist der Feldeffekttransistor 31 leitend gesteuert und das erste Entlastungsnetzwerk 15, 16, 17 wirksam. Bei Schwachlast ist der Feldeffekttransistor 31 gesperrt und das zweite Entlastungsnetzwerk 13, 14, 16, 17 wirksam. Bei diesem besteht der Entladestromzweig aus der Serienschaltung von Diode 13 und Widerstand 14, die den Kondensator 16 des Entlastungsnetzwerkes an die Eingangsspannungsquelle 1 legt.

Bei der ersten RCD-Entlastungsschaltung ist der Entladewiderstand 15 der Diode 17 parallel geschaltet, so daß der Kondensator 16 daher völlig entladen wird. Bei dem zweiten Entlastungsnetzwerk bleibt der Kondensator 16 mindestens noch auf die Versorgungsspannung U1 aufgeladen.

Der Feldeffekttransistor 31 wird über einen an die Hilfswicklung 54 des Transformators 5 angeschlossenen Hilfs-Sperrumrichters angesteuert, der die Spannung U34 am Kondensator 34 erzeugt. An der Hilfswicklung 54 liegt die aus der Diode 35 und dem Kondensator 34 bestehende Serienschaltung. Parallel zum Kondensator 34 liegt eine aus der Emitter- Kollektor-Strecke des Optokopplers 32, 66 und dem Widerstand 33 bestehende Serienschaltung und die Z-Diode 36. Der Widerstand 33 liegt parallel zur Gate-Source-Strecke des Feldeffekttransistors 31.

Die Primärwicklung 51 und die Hilfswicklung 54 sind durch eine eine einzige Wicklung mit Anzapfung gebildet. Die Anzapfung, d.h. der Verbindungspunkt der beiden Wicklungen ist mit dem Drain des Feldeffekttransistors 190 und mit der Source des Feldeffekttransistors 31 verbunden.

Bei Schwachlast und daher wirksamem zweiten Entlastungsnetzwerk 13, 14, 16, 17 wird der Transformator 5 nicht mit Hilfe des Entlastungsnetzwerkes ummagnetisiert. Die Ummagnetisierung erfolgt vielmehr mit Hilfe der Entmagnetisierungswicklung 53, die über die in bezug auf die Eingangsspannung U1 in Sperrichtung gepolte Diode 18 an die Eingangsspannungsquelle 1 angeschlossen ist.

Der Durchflußumrichter enthält eine Steuerschaltung 6 mit einem Komparator 63, der eine Referenzspannung U_{Ref} mit einem Gleichsignal vergleicht, das dem Eingangsstrom des Durchflußumrichters proportional ist. Dieses Gleichsignal wird mit Hilfe der Abtast- und Halteschaltung aus einem Meßwert für den pulsierenden Eingangsstrom I1 gewonnen.

Die Abtast- und Halteschaltung 4 ist an den Stromsensor 41 angeschlossen, der zur Erfassung des Eingangsstromes dient. Der Stromsensor 41 enthält einen Stromwandler, dessen Primärwicklung 411 zwischen Minuspol der Eingangsspannungsquelle 11 und Leistungsschalter 19 im eingangsseitigen Hauptstromkreis des Durchflußumrichters angeordnet ist. Parallel zur Sekundärwicklung 412, die einpolig mit Bezugspotential verbunden ist, liegt der Widerstand 413. Parallel zum Widerstand 413 ist die aus der Diode 414 und dem Widerstand 415 bestehende Serienschaltung angeordnet. An der Bürde des Stromwandlers ergibt sich eine Spannung, die im Voltbereich liegt.

Parallel zum Widerstand 415 liegt die aus dem Widerstand 42 und dem Kondensator 43 bestehende Serienschaltung. Der Verbindungspunkt zwischen Widerstand 42 und Kondensator 43 ist über die Source-Drain-Strecke des Feldeffekttransistors 47 an eine Ausgangsklemme der Abtast- und Halteschaltung 4 und von dort über den Widerstand 61 an den nicht invertierenden Eingang des Komparators 63 geführt. Die Gate-Elektrode des Feldeffekttransistors 47 ist über die Parallelschaltung aus Widerstand 46 und Diode 44 an den Ausgang der Steuerschaltung 20 angeschlossen, der mit der Gate-Elektrode des Leistungsschalters 19 verbunden ist. Zwischen dem Gate des Feldeffekttransistors 47 und Bezugspotential liegt der Kondensator 45. Der Feldeffekttransistor 47 ist ferner mit seiner Source-Elektrode über den Kondensator 43 an Bezugspotential und mit seiner Drain-Elektrode über den Kondensator 48 an Bezugspotential geführt.

Die Abtast- und Halteschaltung 4 bewirkt eine zeitdiskrete Erfassung des pulsförmigen Eingangsstromes I1 über ein aus diskreten Bauteilen zusammengesetztes Abtast- und Halteglied. An die Stelle dieser Anordnung kann gegebenenfalls eine solche mit integriertem Abtast- und Halteglied treten.

Durch die Wirkung des RC-Gliedes 45, 46 setzt das Einschalten des Feldeffekttransistors 47 eine vorgegebene Zeitspanne nach dem Einschalten des Leistungsschalters 19 ein. Die Diode 44 ist so gepolt, daß der Kondensator 45 am Ende der Einschaltzeit des Feldeffekttransistors 47 über die Diode 44 entladen und der Feldeffekttransistor daher unverzögert gesperrt wird.

Auf diese Weise wird der am Ausgang der Abtast- und Halteschaltung 4 liegende Kondensator 48 auf den Scheitelwert der am Widerstand 415 auftretenden Impulsspannung Uₚ aufgeladen. Gegenüber einem Spitzenwert-Gleichrichter mit Diode ergibt sich ein vergleichsweise geringer Spannungsabfall und störende Stromspitzen beim Einschalten des Leistungsschalters 19 werden unterdrückt.

Die Abtast- und Halteschaltung 4 liefert eine Gleichspannung U_{g}, die dem Spitzenwert des Eingangsstromes I1 proportional ist. Da der Ausgangsstrom eine relativ geringe Welligkeit aufweist, ist die Gleichspannung U_{g} dem Mittelwert des Ausgangsstromes I2 proportional.

Der nicht invertierende Eingang des Komparators 63 ist über den Widerstand 61 an die Abtast- und Halteschaltung 4 angeschlossen. Die Abtast- und Halteschaltung 4 liefert ein dem Eingangsstrom des Durchflußumrichters proportionales Gleichsignal. Der nicht invertierende Eingang des Komparators 63 ist ferner über den Kondensator 62 an Masse geführt. Der Ausgang des Komparators 63 ist über den Widerstand 65 an die Hilfsspannung U3 gelegt und über die LED 66 des Optokopplers 66, 32 an Bezugspotential geführt. Zwischen Ausgang und nicht invertierendem Eingang des Komparators 63 liegt der Widerstand 64. Am invertierenden Eingang des Komparators 63 liegt die Referenzspannung U_{Ref} oder eine geteilte Referenzspannung.

Der Durchflußumrichter nach Fig. 1 ermöglicht eine optimale Bemessung der RCD-Beschaltung 15 ... 17 für hohe Ausgangsströme. Hierdurch ist eine minimale Beanspruchung des Leistungsschalters 19 gegeben und eine optimale Ausnutzung des Transformators 5 möglich.

Andererseits werden besonders geringe Verluste im Kondensator 16 umgesetzt. Außerdem kann auch die durch den Widerstand 25 bewirkte Grundlast vergleichsweise gering gehalten werden, da im Schwachlastbetrieb der Transistor 31 gesperrt ist und die Magnetisierungsenergie praktisch vollständig auf den am Eingang des Durchflußumrichters liegenden Kondensator 12 zurückgespeist wird.

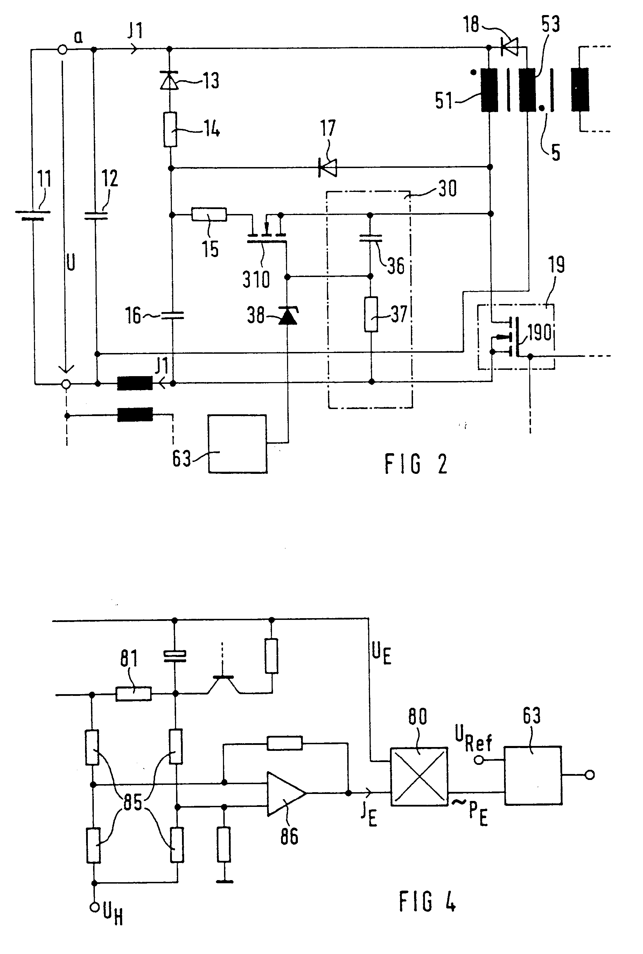

Der Durchflußumrichter nach Fig. 2 stimmt hinsichtlich der nicht gezeigten Schaltungsteile mit dem nach Fig. 1 überein. Abweichend von Fig. 1 ist die Ansteuerung des in Serie zum Widerstand 15 des RCD-Netzwerkes liegenden Feldeffekttransistors 310.

Das Gate des Feldeffekttransistors 310 ist über die Z-Diode 38 an den Ausgang des Komparators 63 angeschlossen. Zwischen dem Gate und der Source des Feldeffekttransistors 310 liegt anstelle des Widerstands 33 der Kondensator 36.

Die bei dem Durchflußumrichter nach Fig. 2 vorgesehene Ansteuerung des Feldeffekttransistors 310 ist vorzugsweise bei relativ großen Tastverhältnissen trotz des an allen Anschlüssen des Feldeffekttransistors 310 springenden Potentials zweckmäßig.

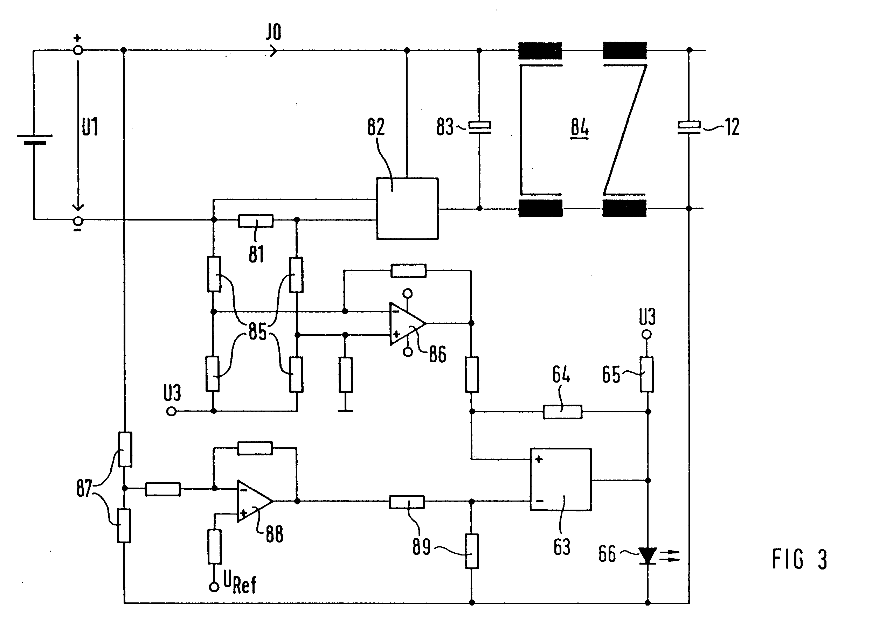

Fig. 3 zeigt für den Durchflußumrichter nach Fig. 1 oder 2 eine Schaltungsanordnung, bei der ein mit der Eingangsspannung gewichteter Mittelwert des Eingangsstromes gebildet wird. Diese Schaltungsanordnung kann gegebenenfalls an die Stelle der Abtast- und Halteschaltung 4 des Durchflußumrichters nach Fig. 1 oder 2 treten.

Der Kondensator 12, der am Eingang eines in Fig. 3 nicht dargestellten und entsprechend Fig. 1 oder 2 aufgebauten Durchflußumrichters liegt, ist über die Filteranordnung 84 an den Kondensator 83 angeschlossen. Der Kondensator 83 wird aus der Eingangsspannungsquelle 11 über den Widerstand 81 und die Vorrichtung 82 zur Begrenzung und/oder Verzögerung des Einschaltstromes gespeist. Eine Vorrichtung zur Verzögerung und Begrenzung des Einschaltstromes ist. z.B. aus der EP-A1 0 272 514 bekannt.

Mit Hilfe des Meßwiderstandes 81 wird der Mittelwert des Eingangsgleichstromes I0 gemessen. Durch Gewichtung mit der Eingangsspannung U1 wird daraus das Ansteuersignal für den Komparator 63 gewonnen. Der für die Vorrichtung 82 sowieso erfaßte Gleichstrom I0 wird zur Festlegung des Schaltzeitpunktes für das Ansprechen des Komparators 63 verwendet. Dieser Gleichstrom I0 ändert sich in Abhängigkeit vom Ausgangsstrom I2 und in Abhängigkeit von der Eingangsspannung U1.

Im Hinblick auf eine veränderbare Eingangsspannung U1 wird die Abhängigkeit des Gleichstroms I0 von der Eingangsspannung dadurch berücksichtigt, daß der Komparator 63 abhängig von der aufgenommenen Leistung, d.h. von der Eingangsleistung geschaltet wird.

Der Verstärker 86 ist über die Widerstandsbrücke 85 an den Meßwiderstand 81 angeschlossen und verstärkt die relativ kleinen Spannungswerte, die am Strommeßwiderstand 81 auftreten, in Werte, die im Voltbereich liegen. Der Ausgang des Verstärkers 86 ist an den nicht invertierenden Eingang des Komparators 63 geführt.

Der Verstärker 88, dessen invertierendem Eingang über den Spannungsteiler 87 ein Bruchteil der Eingangsspannung zugeführt wird und dessen nicht invertierender Eingang an der Referenzspannung U_{Ref} liegt, invertiert seine Eingangsspannung. Über den Spannungsteiler 89 wird dem invertierenden Eingang des Komparators 63 ein Bruchteil der Ausgangsspannung des Verstärkers 88 zugeführt.

Steigt die Eingangsspannung U1 und sinkt dadurch bedingt der Eingangsstrom I0, so fällt auch die Spannung am invertierenden Eingang des Komparators 63. Der Komparator 63 verharrt somit in seinem Schaltzustand.

Wird dagegen der Eingangsstrom I0 aufgrund einer Änderung des Ausgangsstromes I2 verändert, verändert sich nur die Spannung am nicht invertierenden Eingang des Komparators 63. Daher kann in diesem Fall das Entlastungsnetzwerk des Durchflußumrichters nach Fig. 1 oder 2 mit Hilfe des Komparators 63 umgeschaltet werden.

Ist eine konstante Eingangsspannung U1 sichergestellt, so kann das verstärkte Stromsignal den Komparator 63 abweichend von Fig. 3 direkt ansteuern.

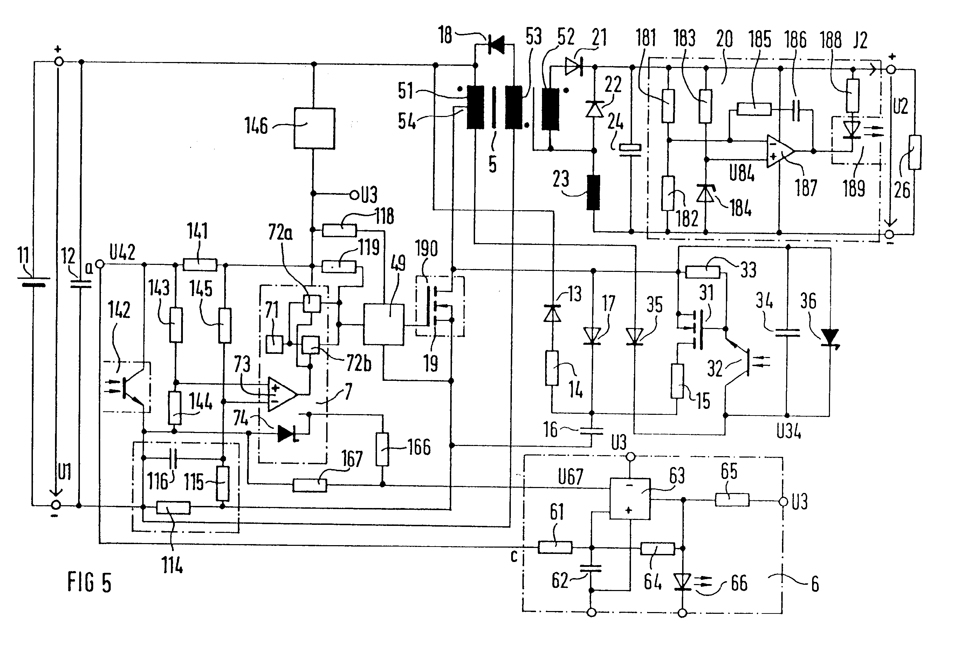

Fig. 4 zeigt in Abwandlung der Schaltungsanordnung nach Fig. 3 eine Anordnung mit Analog-Multiplzierer 80. Der Analog-Multiplizierer 80 bestimmt durch Multiplikation von Eingangsspannung und mittlerem Eingangsstrom I0 die mittlere Eingangsleistung . Der Komparator 63 vergleicht die mittlere Eingangsleistung mit einem Grenzwert und schaltet das Entlastungsnetzwerk gegebenenfalls ein.

Der Eintakt-Durchflußumrichter nach Fig. 5 stimmt mit dem nach Fig. 1 weitgehend überein. Abweichend ist die Art, in der die dem Ausgangsstrom proportionale Gleichspannung erzeugt wird.

Der Feldeffekttransistor 190 ist mit seinem Steuereingang an den Treiber 49 angeschlossen. Der Treiber 49 liegt über den Widerstand 118 an der Hilfsspannung U3 und wird von der Steuerschaltung 7 gesteuert.

Die Steuerschaltung 7 enthält den Taktgeber 71, die vom Taktgeber 71 und vom Komparator 73 gesteuerten Impulsdauermodulatoren 72a und 72b sowie die Referenzspannungsquelle 74. Die beiden Impulsdauermodulatoren 72a und 72b bilden eine Vorrichtung zur Impulsdauermodulation, die taktgesteuert eine Folge von impulsdauermodulierten Einschaltimpulsen über den Treiber 49 an den Steuereingang des Leistungsschalters 19 abgibt.

Die Steuerschaltung 20 enthält einen Regler für die Ausgangsspannung U2. Als Fehlerverstärker für die Ausgangsspannung U2 dient der Differenzverstärker 187. Der invertierende Eingang des Differenzverstärkers 187 ist an den Abgriff des aus den Widerständen 181 und 182 bestehenden, parallel zum Ausgang des Durchflußumrichters angeordneten Spannungsteilers 181, 182 angeschlossen. Mit Hilfe der aus dem Widerstand 183 und der Z-Diode 184 bestehenden Serienschaltung wird die Referenzspannung U84 gewonnen, die an den nicht invertierenden Eingang des Differenzverstärkers 187 geführt ist. Zwischen dem Ausgang und dem invertierenden Eingang des Differenzverstärkers 187 liegt die aus dem Widerstand 185 und dem Kondensator 186 bestehende Serienschaltung. Der Ausgang des Differenzverstärkers 187 ist über die aus der Fotodiode 189 und dem Widerstand 188 bestehende Serienschaltung an den Pluspol des Umrichterausgangs geführt. Die Fotodiode 189 ist Bestandteil des Optokopplers 189, 142.

Der zum Optokoppler 189, 142 gehörende Fototransistor 142 liegt mit seinem Emitter am Minuspol des Umrichtereingangs und ist mit seinem Kollektor über den Widerstand 46 an die mit Hilfe des Vorreglers 146 gewonnene Hilfsspannung U3 geführt, die eine konstante Gleichspannung ist. Am Ausgang des Vorreglers 146 liegt somit ein Spannungsteiler, der aus dem Widerstand 141 und der Kollektor-Emitterstrecke des Fototransistors 42 besteht.

Parallel zu dem im primärseitigen Wechselstromzwischenkreis liegenden Widerstand 114 liegt die aus dem Widerstand 115 und dem Kondensator 116 bestehende Serienschaltung. Der Kondensator 116 ist dabei mit dem Minuspol des Umrichtereingangs verbunden. Diese Serienschaltung 115, 116 bildet ein RC-Glied, mit dessen Hilfe die am Widerstand 114 auftretende Meßspannung von störenden Spitzen befreit wird, die jeweils beim Beginn der Einschaltphase des Leistungsschalters 19 entstehen.

Am Verbindungspunkt zwischen Widerstand 115 und Kondensator 116, d.h. am Ausgang des RC-Gliedes 115, 116 liegt der invertierende Eingang des Komparators 73. Der nicht invertierende Eingang des Komparators 73 ist mit dem Abgriff des aus den Widerständen 143 und 144 bestehenden und parallel zur Kollektor-Emitterstrecke des Fototransistors 142 liegenden Spannungsteilers angeschlossen.

Der invertierende Eingang des Komparators 73 ist außerdem über den Widerstand 145 an die Hilfsspannung U3 geführt. Der Widerstand 145 bewirkt eine leichte Anhebung des Potentials am invertierenden Eingang des Komparators 73, z.B. um etwa 100 mV. Hierdurch wird sichergestellt, daß das Potential am nicht invertierenden Eingang des Komparators 73 im Leerlauffall das Potential am invertierenden Eingang des Komparators 73 unterschreiten und die Steuerschaltung 7 zur Begrenzung der Ausgangsspannung Ansteuerimpulse auslassen kann. Der Widerstand 145 kann entfallen, wenn am Ausgang des Durchflußumrichters eine ausreichende Vorlast vorhanden ist.

Der Durchflußumrichter weist somit eine Konstantspannungsregelung mittels unterlagerter Stromregelung, d.h. eine sogenannte Current-Mode-Regelung auf.

Die Referenzspannungsquelle 74 ist einpolig mit dem Minuspol des Umrichtereingangs verbunden. An die Referenzspannungsquelle 74 ist der aus den Widerständen 166 und 167 bestehende Spannungsteiler angeschlossen, an dessen Abgriff die weitere Referenzspannung U67 zur Verfügung steht.

Der Komparator 63 vergleicht die eigene Referenzspannung U67 mit der Gleichspannung U42, die ein Maß für den Ausgangsstrom I2 des Durchflußumrichters ist und am Anschluß a zur Verfügung steht.

In vorteilhafter Weise wird dabei das vom Spannungsregler am Fototransistor 142 erzeugte Signal zugleich als Meßgröße für den Ausgangsstrom I2 verwendet.

Die Steuerschaltung 7 kann insbesondere ein Steuer-IC vom Typ TDA 4718 sein.

## Patentansprüche

1. Durchflußumrichter, in dessen primärseitigen, an eine Eingangsgleichspannungsquelle (11) anschließbaren Hauptstromkreis in Serie zu einer Wicklung (51) eines Transformators (5) ein Leistungsschalter (19) angeordnet ist und bei dem an wenigstens eine Wicklung (52) des Transformators (5) ein ausgangsseitiger Hauptstromkreis mit einer Gleichrichterdiode (21), einer Freilaufdiode (22) und einer Drossel (23) angeschlossen ist und der ein parallel zum Leistungsschalter (19) ein RCD-Netzwerk (15 ... 17) zur Entlastung des Leistungsschalters (19) aufweist, das einen Kondensator (16) und eine zum Kondensator (16) in Serie liegende, aus einem Widerstand (15) und einer Diode (17) bestehende Parallelschaltung enthält,
**dadurch gekennzeichnet,**
daß der Kondensator (16) des RCD-Netzwerkes (15 ... 17) mit einem seiner Anschlüsse an einen der beiden Pole der Eingangsgleichspannungsquelle (11) geführt ist und mit seinem anderen Anschluß über eine Serienschaltung aus einem Widerstand (14) und einer Diode (13) an den anderen Pol (+) der Eingangsgleichspannungsquelle (11) geführt ist und daß in Serie zum Widerstand (15) des RCD-Netzwerkes ein durch eine Steuervorrichtung (6) steuerbarer elektronischer Schalter (31, 310) angeordnet ist.

2. Durchflußumrichter nach Anspruch 1,
**dadurch gekennzeichnet,** daß der Durchflußumrichter eine Sensoranordnung (41 ... 43, 4) enthält, die als Maß für den Ausgangsstrom des Durchflußumrichters eine Gleichgröße (U_{g}) liefert und daß eine an die Sensoranordnung (41 ... 43, 4) angeschlossenen Steuervorrichtung (6) einen Komparator (63) enthält, der die Gleichgröße (U_{g}) mit einer Bezugsgröße (U_{Ref}) vergleicht.

3. Durchflußumrichter nach Anspruch 1 oder 2,
**dadurch gekennzeichnet,**
daß bei Ausbildung als Eintaktschaltung eine zusätzliche Wicklung (53) des Transformators (5) über eine Diode (18) an die Eingangsgleichspannungsquelle (11) geführt ist.

4. Durchflußumrichter nach einem der Ansprüche 1 bis 3,
**dadurch gekennzeichnet,**
daß der durch die Steuervorrichtung steuerbare elektronische Schalter ein Feldeffekttransistor (31) ist, dessen Gate- Source-Strecke über den Fototransistor (32) eines Opto-Kopplers (66, 32) an eine Hilfsspannungsquelle (U34) angeschlossen ist und daß die LED (66) des Opto-Kopplers (66, 32) an die Steuervorrichtung (6) angeschlossen ist.

5. Durchflußumrichter nach Anspruch 4,
**dadurch gekennzeichnet,**
daß die Hilfsspannungsquelle eine mit dem Leistungsschalter (19) verbundene Hilfswicklung des Transformators (5) und eine daran angeschlossene Gleichrichteranordnung (Diode 35) mit Siebkondensator (Kondensator 34) enthält.

6. Durchflußumrichter nach einem der Ansprüche 1 bis 3,
**dadurch gekennzeichnet**,
daß der durch die Steuervorrichtung steuerbare elektronische Schalter ein Feldeffekttransistor (310) ist, dessen Gate-Source-Strecke parallel zu einem Kondensator (36) angeordnet ist, und daß das Gate des Feldeffekttransistors (310) über eine Entkopplungsdiode (38) an den Ausgang der Steuervorrichtung (63) angeschlossen und über einen Entladewiderstand (37) an ein Bezugspotential geführt ist.

7. Durchflußumrichter nach einem der Ansprüche 1 bis 6,
**dadurch gekennzeichnet,**
daß die Sensoranordnung (41 ... 43, 4) eine Abtast- und Halteschaltung (4) enthält, die einen gemeinsam mit dem Leistungsschalter (19) steuerbaren Feldeffekttransistor (47) mit nachfolgendem Speicherkondensator (Kondensator 48) enthält.

8. Durchflußumrichter nach einem der Ansprüche 1 bis 6,
**dadurch gekennzeichnet,**
daß die Sensoranordnung eine Vorrichtung zur Messung der vom Durchflußumrichter aufgenommenen Eingangsleistung durch Gewichtung des Mittelwertes des Eingangsstromes mit der Eingangsspannung (U1) enthält.

9. Durchflußumrichter nach einem der Ansprüche 1 bis 8,
**dadurch gekennzeichnet,**
daß bei Regelung der Ausgangsspannung (U2) des Durchflußumrichters mittels einer Spannungsregelung mit unterlagerter Stromregelung, bei der eine Vorrichtung zur Erzeugung eines Fehlersignals aus der Ausgangsspannung ein Fehlersignal ableitet, das mit Hilfe eines Komparators mit einer dem Ausgangsstrom (I2) proportionalen, aus trapezförmigen Impulsen bestehenden Meßspannung verglichen wird, die die Steuervorrichtung (6) steuernde Sensoranordnung durch die Vorrichtung zur Erzeugung des Fehlersignals gebildet ist, und daß das dem Ausgangsstrom proportionale Gleichsignal das vom Spannungsregler am Stromkomparator erzeugte Signal ist.

## Claims

1. Forward converter, in whose primary-side main circuit, which can be connected to an input DC voltage source (11), a power switch (19) is arranged in series with a winding (51) of a transformer (5), and in the case of which an output-side main circuit having a rectifier diode (21), a freewheeling diode (22) and an inductor (23) is connected to at least one winding (52) of the transformer (5), and which has, in parallel with the power switch (19), an RCD network (15 ... 17) in order to relieve the load on the power switch (19), which RCD network (15 ... 17) contains a capacitor (16) and a parallel circuit which is connected in series with the capacitor (16) and comprises a resistor (15) and a diode (17), characterized in that the capacitor (16) of the RCD network (15 ... 17) is connected by one of its connections to one of the two poles of the input DC voltage source (11) and is connected by its other connection via a series circuit comprising a resistor (14) and a diode (13) to the other pole (+) of the input DC voltage source (11), and in that an electronic switch (31, 310), which can be controlled by a control device (6), is arranged in series with the resistor (15) of the RCD network.

2. Forward converter according to Claim 1, characterized in that the forward converter contains a sensor arrangement (41 ... 43, 4) which supplies a zero-frequency variable (U_{g}) as a measure of the output current of the forward converter, and in that a control device (6) which is connected to the sensor arrangement (41 ...
43, 4) contains a comparator (63) which compares the zero-frequency variable (U_{g}) with a reference variable (U_{Ref}).

3. Forward converter according to Claim 1 or 2, characterized in that, when designed as a single-ended circuit, an additional winding (53) of the transformer (5) is connected via a diode (18) to the input DC voltage source (11).

4. Forward converter according to one of Claims 1 to 3, characterized in that the electronic switch, which can be controlled by the control device, is a field-effect transistor (31) whose gate-source junction is connected via the photo transistor (32) of an optocoupler (66, 32) to an auxiliary voltage source (U34), and in that the LED (66) of the optocoupler (66, 32) is connected to the control device (6).

5. Forward converter according to Claim 4, characterized in that the auxiliary voltage source contains an auxiliary winding, which is connected to the power switch (19), of the transformer (5) and a rectifier arrangement (diode 35), which is connected thereto, having a filter capacitor (capacitor 34).

6. Forward converter according to one of Claims 1 to 3, characterized in that the electronic switch, which can be controlled by the control device, is a field-effect transistor (310) whose gate-source junction is arranged in parallel with a capacitor (36), and in that the gate of the field-effect transistor (310) is connected via a decoupling diode (38) to the output of the control device (63), and is connected via a discharge resistor (37) to a reference potential.

7. Forward converter according to one of Claims 1 to 6, characterized in that the sensor arrangement (41 ... 43, 4) contains a sample and hold circuit (4) which contains a field-effect transistor (47), which can be controlled jointly with the power switch (19), having a downstream storage capacitor (capacitor 48).

8. Forward converter according to one of Claims 1 to 6, characterized in that the sensor arrangement contains a device for measuring the input power fed in to the forward converter by weighting the mean value of the input current by the input voltage (U1).

9. Forward converter according to one of Claims 1 to 8, characterized in that, in the case of regulation of the output voltage (U2) of the forward converter by means of voltage regulation with subordinate current regulation, in the case of which a device for producing an error signal derives an error signal from the output voltage, which error signal is compared, with the aid of a comparator, with a measurement voltage which is proportional to the output current (I2) and comprises trapezoidal pulses, the sensor arrangement which controls the control device (6) is formed by the device for producing the error signal, and in that the zero-frequency signal which is proportional to the output current is the signal which is produced on the current comparator by the voltage regulator.

## Revendications

1. Convertisseur direct, dont le circuit principal, qui est situé côté primaire et peut être raccordé à une source de tension continue d'entrée (11), contient un interrupteur de puissance (19) branché en série avec un enroulement (51) d'un transformateur (5) et dans lequel un circuit principal situé côté sortie comportant une diode redresseuse (21), une diode de roue libre (22) et une bobine (23) est raccordé à au moins un enroulement (52) du transformateur (5), ce convertisseur statique comportant, en parallèle avec l'interrupteur de puissance (19), un réseau RCD (15...17), qui sert à décharger l'interrupteur de puissance (19) et qui contient un condensateur (16) et un circuit parallèle branché en série avec le condensateur (16) et constitué d'une résistance (15) et une diode (17), caractérisé par le fait que le condensateur (16) du réseau RCD (15...17) est raccordé, par l'une de ses bornes, à l'un des deux pôles de la source de tension continue d'entrée (11) et, par son autre borne, par l'intermédiaire d'un circuit série formé d'une résistance (14) et d'une diode (13), à l'autre pôle (+) de la source de tension continue d'entrée (11), et qu'un interrupteur électronique (31,310) commandable par un dispositif de commande (6) est disposé en série avec la résistance (15) du réseau RCD.

2. Convertisseur direct suivant la revendication 1, caractérisé par le fait que le convertisseur direct contient un dispositif de capteurs (41...43,4), qui délivre une grandeur continue (U_{g}) en tant que mesure du courant de sortie du convertisseur direct, et qu'un dispositif de commande (6) raccordé au dispositif de capteurs (41...43,4) contient un comparateur (63), qui compare la grandeur continue (U_{g}) à une grandeur de référence (U_{Ref}).

3. Convertisseur direct suivant la revendication 1 ou 2, caractérisé par le fait que dans le cas de sa réalisation sous la forme d'un circuit à une alternance, un enroulement supplémentaire (53) du transformateur (5) est relié par l'intermédiaire d'une diode (18) à la source de tension continue d'entrée (11).

4. Convertisseur direct suivant l'une des revendications 1 à 3, caractérisé par le fait que l'interrupteur électronique commandable par le dispositif de commande est un transistor à effet de champ (31), dont la voie grille-source est raccordée, par l'intermédiaire du phototransistor (32) d'un coupleur optoélectronique (66,32), à une source de tension auxiliaire (U34) et que la diode LED (66) du coupleur optoélectronique (66,32) est raccordée au dispositif de commande (6).

5. Commutateur direct suivant la revendication 4, caractérisé par le fait que la source de tension auxiliaire contient un enroulement auxiliaire, qui est relié à l'interrupteur de puissance (19), du transformateur (5) et un dispositif redresseur (diode 35) raccordé à cet enroulement et comportant un condensateur de lissage (condensateur 34).

6. Convertisseur direct suivant l'une des revendications 1 à 3, caractérisé par le fait que l'interrupteur électronique commandable au moyen du dispositif de commande est un transistor à effet de champ (310), dont la voie grille-source est branchée en parallèle avec un condensateur (36), et que la grille du transistor à effet de champ (310) est raccordée à la sortie du dispositif de commande (63) par l'intermédiaire d'une diode de découplage (38) et est reliée à un potentiel de référence par l'intermédiaire d'une résistance de décharge (37).

7. Convertisseur direct suivant l'une des revendications 1 à 6, caractérisé par le fait que le dispositif de capteurs (41...43, 4) contient un circuit d'échantillonnage et de maintien (4), qui contient un premier transistor à effet de champ (47), qui est commandable en commun avec l'interrupteur de puissance et en aval duquel est branché un condensateur d'accumulation (condensateur 48).

8. Convertisseur direct suivant l'une des revendications 1 à 6, caractérisé par le fait que le dispositif de capteurs contient un dispositif pour mesurer la puissance d'entrée absorbée par le convertisseur direct, au moyen d'une pondération de la valeur moyenne du courant d'entrée par la tension d'entrée (U1).

9. Convertisseur direct suivant l'une des revendications 1 à 8, caractérisé par le fait que, dans le cas de la régulation de la tension de sortie (U2) du convertisseur direct au moyen d'une régulation de tension, à laquelle est asservie une régulation de courant, lors de laquelle un dispositif servant à produire un signal d'erreur obtient, à partir de la tension de sortie, un signal d'erreur, qui est comparé, à l'aide d'un comparateur, à une tension de mesure, qui est proportionnelle au courant de sortie (I2) et est constitué d'impulsions trapézoïdales, et que le dispositif de capteurs, qui commande le dispositif de commande (6), est formé par le dispositif servant à produire le signal d'erreur, et que le signal continu, qui est proportionnel au courant de sortie, est le signal produit par le régulateur de tension dans le comparateur de courant.
